# EUROPEAN PATENT APPLICATION

(11) **EP 2 384 109 A1**
(43) Date of publication of application: **02.11.2011**
(21) Application number: 10738358.0
(22) Date of filing: 04.02.2010
(51) Int. Cl.: H05K 7/20, F24F 7/08

(54) **HEAT EXCHANGER DEVICE AND HEATING ELEMENT HOLDER USING SAME**

(30) Priority: 09.02.2009 JP 2009026902; 12.05.2009 JP 2009115407; 16.09.2009 JP 2009213949; 19.11.2009 JP 2009263736
(71) Applicant: Panasonic Corporation, Kadoma-shi Osaka 571-8501 (JP)
(72) Inventor: KEISUKE, Tsuji, Osaka 540-6207 (JP); MUTSUHIKO, Matsumoto, Osaka 540-6207 (JP); NAOYUKI, Funada, Osaka 540-6207 (JP); NIROSHI, Shibata, Osaka 540-6207 (JP); TAKAHIRO, Sahashi, Osaka 540-6207 (JP); HIROTAKA, Soga, Osaka 540-6207 (JP); KEISUKE, Hagimoto, Osaka 540-6207 (JP)
(74) Representative: Schwabe - Sandmair - Marx
(86) International application number: PCT/JP2010/000662
(87) International publication number: WO 2010/090017

(57) **Abstract**

A heat exchanger device of the invention having a body case provided with a first air intake port and a first discharge port for a first environment in a front surface thereof, and a second air intake port and a second discharge port for a second environment in a back surface thereof, an air-blow fan for the first environment provided in the body case, and a heat exchanger inside the body case for exchanging heat between the air in the first environment and the air in the second environment, and is configured such that opposed two surfaces are provided with an air suction port for a first environment and an air suction port for a second environment, respectively, and the other surface is provided with an air blow-off port for the first environment and an air blow-off port for the second environment, respectively. A surface provided with the air suction port for the first environment is directed to the air-blow fan, and a chamber is formed between the second air intake port and the air suction port for the second environment.

## Description

### TECHNICAL FIELD

The present invention relates to a heat exchanger device and a heating element holder using the same.

### BACKGROUND ART

A cellular phone base station, for example, is sometimes expressed as a heating element because it has a large current flow of several tens of amperes. It is also considered a heating element having high electric power consumption in light of its electric power consumption. Accordingly, cooling the generated heat is extremely important in order to stabilize the performance of the base station of the cellular phone. The cellular phone base station as mentioned above is provided with the following configuration for carrying out its cooling.

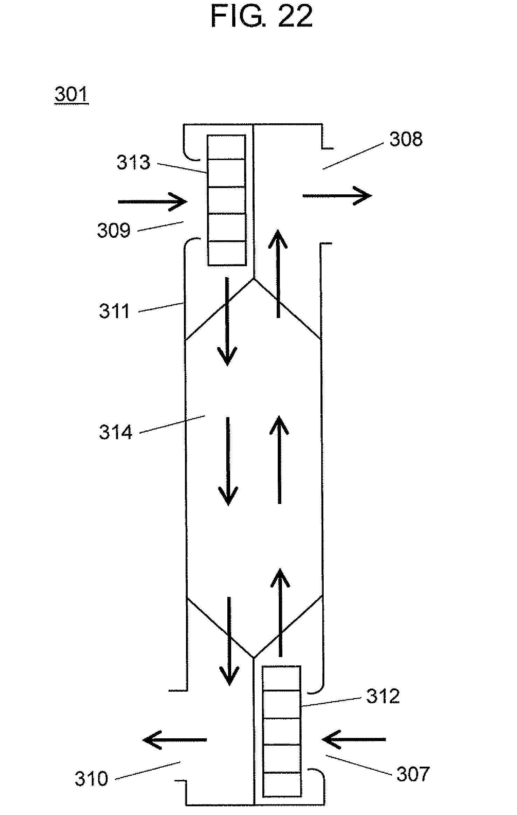

FIG. 22 is a cross sectional view schematically showing a configuration of a conventional heat exchanger device.

The cellular phone base station is configured to include an electronic circuit and the like, and is generally arranged in a casing such as a cabinet protecting them from an external natural environment. The cabinet houses a transmitting and receiving portion serving as a protection heating element in its inner portion, for example, and is configured such that heat exchanger device 301 as shown in FIG. 22 is provided in an opening portion of the cabinet. Further, as shown in FIG. 22, heat exchanger device 301 is structured to be provided with body case 311, first air blower 312 and second air blower 313 provided in body case 311, and heat exchanger 314 carrying out heat exchange between outdoor air and air in the cabinet (not shown) in body case 311 (refer to Patent Document 1 which shows similar technology). In this case, body caste 311 has first suction port 307 sucking the outdoor air and first discharge port 308 discharging the outdoor air, and second suction port 309 sucking the air in the cabinet and second discharge port 310 discharging the air into the cabinet. First air blower 312 blows the ambient air to heat exchanger device 301, and second air blower 313 blows the air inside the cabinet to heat exchanger device 301.

Conventional heat exchanger device 301 mentioned above has a configuration in which two air blowers, that is, first air blower 312 blowing the ambient air and second air blower 313 blowing the air inside the cabinet, and heat exchanger 314 are housed in one body case 311, and hence body case 311 itself becomes large. On the other hand, the base station of the cellular phone is advanced in its downsizing, and it is strongly required to reduce the size of the heat exchanger device main body.

### PRIOR ART DOCUMENT

### PATENT DOCUMENT

Patent Document 1: Unexamined Japanese Patent Publication No. 2000-161875

### DISCLOSURE OF THE INVENTION

Accordingly, an object of the present invention is to downsize a heat exchanger device.

The heat exchanger device according to the present invention includes: a body case provided with a first air intake port and a first discharge port for a first environment in a front surface thereof, and a second air intake port and a second discharge port for a second environment in a back surface thereof; an air-blow fan for the first environment provided in the body case; and a heat exchanger inside the body case for exchanging heat between the air in the first environment and the air in the second environment, wherein the heat exchanger includes a multilayered body having a plurality of parallelogram plate bodies multilayered with predetermined distances, the multilayered body having the multilayered parallelogram plate bodies is provided with an air suction port for the first environment and an air suction port for the second environment in two opposed surfaces thereof, the multilayered body having the multilayered parallelogram plate bodies is further provided with an air blow-off port for the first environment in one of the other surfaces formed thereon, and an air blow-off port for the second environment in another surface opposed to the surface having the air blow-off port for the first environment, the surface provided with the air suction port for the first environment is directed to the air-blow fan, the air blow-off port for the first environment is placed in contact with the first discharge port formed in the body case and the air blow-off port for the second environment is placed in contact with the second discharge port formed in the body case, and the heat exchanger has a chamber formed between the second air intake port and the air suction port for the second environment.

With this configuration, since it has the chamber which is formed between the second air intake port and the air suction port for the second environment, and can change a direction of the air blower by the chamber, it is possible to arrange the air-blow fan for the second environment in an outer portion of the heat exchanger device. Therefore, it is possible to downsize the heat exchanger device.

Further, a heating element holder according to the present invention comprises using the heat exchanger device described above.

With this configuration, by using the downsized heat exchanger device, a downsized heating element holder can be realized. Further, by using the heat exchanger device having the chamber, it becomes possible to select a place where the air-blow fan for the second environment is installed, enlarge a design freedom of a parts layout, and further downsize the heating element holder.

### BRIEF DESCRIPTION OF THE DRAWINGS

FIG. 1 is a perspective view showing an installation example of a heating element holder using a heat exchanger device according to Embodiment 1 of the present invention.
FIG. 2 is a configuration view of the heat exchanger device according to Embodiment 1 of the present invention as seen from a cross section.
FIG. 3 is a configuration view of the heat exchanger device and the heating element holder according to Embodiment 1 of the present invention as seen from a cross section.
FIG. 4 is a back elevational view of the heat exchanger device according to Embodiment 1 of the present invention.
FIG. 5 is an exploded view of a heat exchanger which is used in the heat exchanger device according to Embodiment 1 of the present invention.
FIG. 6 is a perspective view showing the heat exchanger which is used in the heat exchanger device according to Embodiment 1 of the present invention.
FIG. 7 is a configuration view of the heat exchanger device according to Embodiment 1 of the present invention as seen from an exploded cross section.
FIG. 8 is a perspective view relating to a cover assembly of the heat exchanger device according to Embodiment 1 of the present invention.
FIG. 9 is a perspective view of a heat exchanger device according to Embodiment 2 of the present invention.
FIG. 10 is a configuration view of an exploded cross section of the heat exchanger device according to Embodiment 2 of the present invention.
FIG. 11 is a configuration view of an enlarged cross section of a heat exchanger portion of the heat exchanger device according to Embodiment 2 of the present invention.
FIG. 12 is a perspective view of a circulation fan portion of a heat exchanger device according to Embodiment 3 of the present invention.
FIG. 13 is a perspective view obtained by cutting a part of the circulation fan portion of the heat exchanger device according to Embodiment 3 of the present invention.
FIG. 14 is a configuration view of an exploded cross section of the circulation fan portion of the heat exchanger device according to Embodiment 3 of the present invention.
FIG. 15 is an exploded perspective view of the circulation fan portion of the heat exchanger device according to Embodiment 3 of the present invention.
FIG. 16 is a perspective view of a heat exchanger device according to Embodiment 4 of the present invention.
FIG. 17 is a perspective view of a scroll casing of the heat exchanger device according to Embodiment 4 of the present invention:
FIG. 18 is a perspective view of a motor fixing plate of the heat exchanger device according to Embodiment 4 of the present invention.
FIG. 19 is a perspective view showing an air-blow fan mounting configuration of the heat exchanger device according to Embodiment 4 of the present invention.
FIG. 20 is a plan view obtained by enlarging a main part of an installation of the air-blow fan of the heat exchanger device according to Embodiment 4 of the present invention.
FIG. 21 is a cross sectional view showing a configuration of the heat exchanger device according to Embodiment 4 of the present invention to which a motor is attached.
FIG. 22 is a cross sectional view schematically showing a configuration of a conventional heat exchanger device.

### PREFERRED EMBODIMENTS FOR CARRYING OUT OF THE INVENTION

A description will be given below of an embodiment according to the present invention with reference to the accompanying drawings. In the following drawings, since like components are denoted by like reference marks, and the description thereof may sometimes be omitted.

### (Embodiment 1)

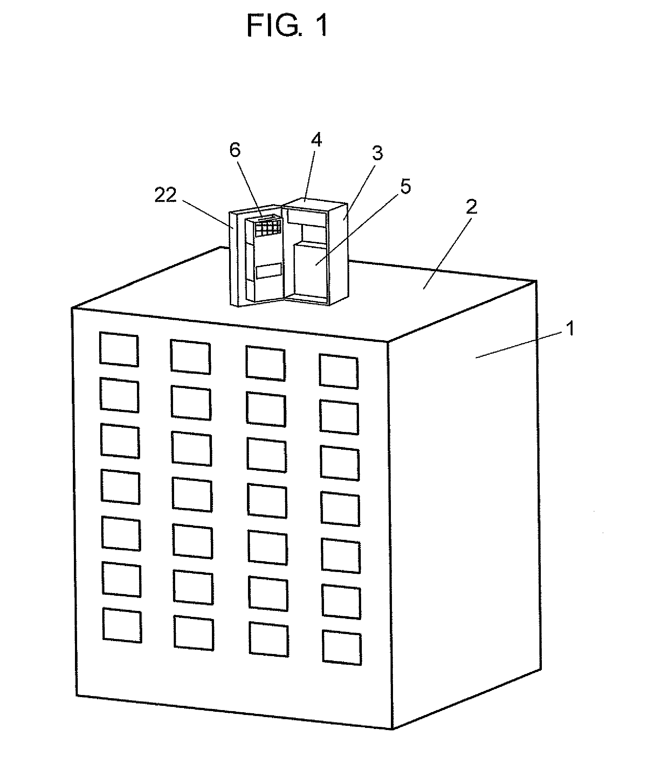

FIG. 1 is a perspective view showing an installation example of a heating element holder using a heat exchanger device according to Embodiment 1 of the present invention.

As shown in FIG. 1, a cellular phone base station 3 is provided on rooftop 2 of building 1 housing offices and the like. Base station 3 includes, for example, box-like cabinet 4, transmitting and receiving portion 5 provided in the cabinet 4, and a heat exchanger device 6 provided in the front opening portion of cabinet 4. In this case, heat exchanger device 6 is installed in the back surface of door 22, and can move together with door 22 so as to freely open and close.

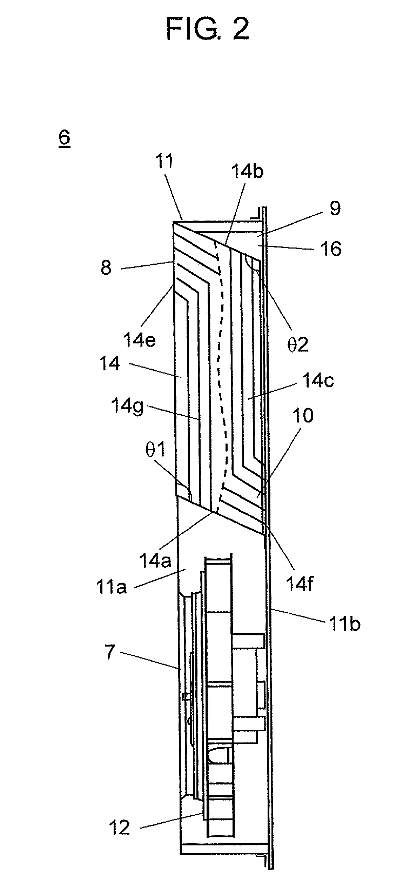

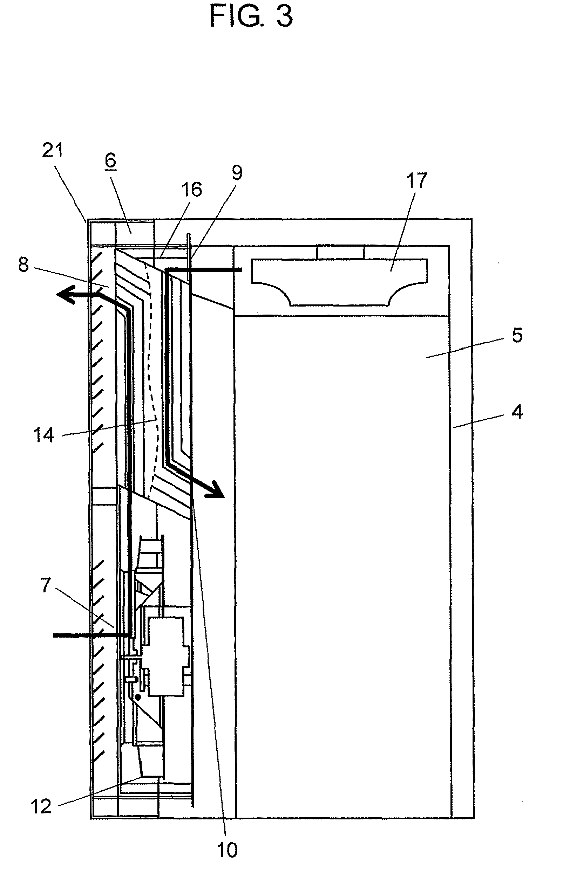

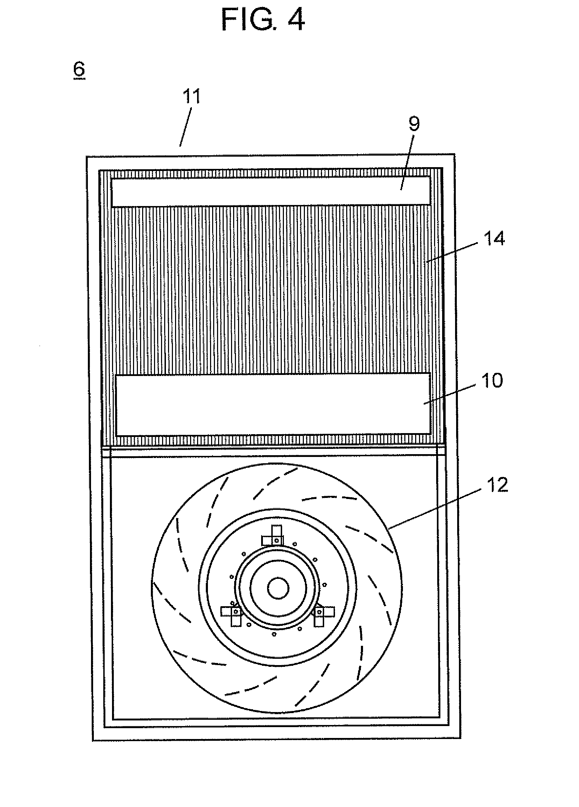

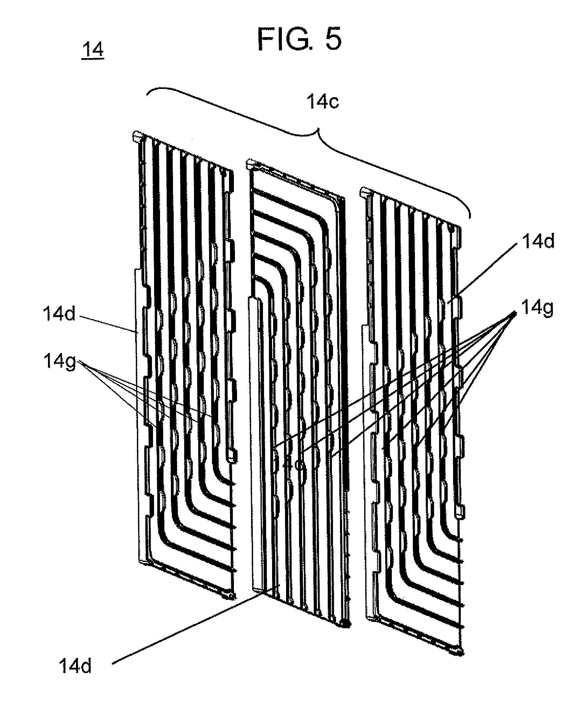

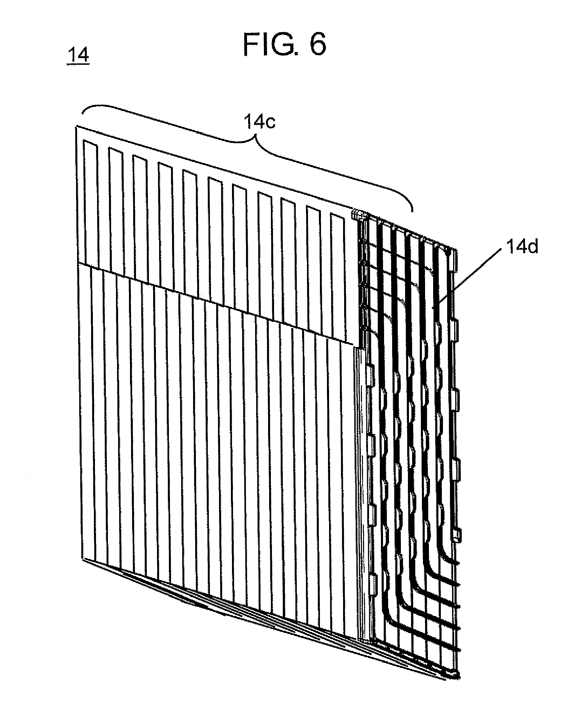

FIG. 2 is a configuration view of the heat exchanger device according to Embodiment 1 of the present invention as seen from a cross section, and FIG. 3 is a configuration view of the heat exchanger device and the heating element holder according to Embodiment 1 of the present invention as seen from a cross section. Further, FIG. 4 is a back elevational view of the heat exchanger device according to Embodiment 1 of the present invention. FIG. 5 is an exploded view of a heat exchanger which is used in the heat exchanger device according to Embodiment 1 of the present invention, and FIG. 6 is a perspective view showing the heat exchanger which is used in the heat exchanger device according to Embodiment 1 of the present invention.

As shown in FIGS. 2 to 4, heat exchanger device 6 according to Embodiment 1, is provided with body case 11, air-blow fan 12 for a first environment, and heat exchanger 14. In this case, body case 11 is provided with first air intake port 7 and first discharge port 8 for a first environment which suck or discharge outside air, in a front surface 11a thereof, and second air intake port 9 and second discharge port 10 for a second environment which suck or discharge air in cabinet 4, in a back surface 11b thereof. Blower fan 12 for the first environment is provided in body case 11. Heat exchanger 14 carries out a heat exchange between the air for the first environment and the air for the second environment, in body case 11.

Heat exchanger 14 includes, as shown in FIG. 5, parallelogram columnar shaped multilayered body 14c having a plurality of parallelogram plate bodies 14d multilayered with predetermined distances In heat exchanger 14, air suction port 14a for the first environment and air suction port 14b for the second environment are provided in two opposed surfaces formed on the multilayered body 14c. Air blow-off port 14e for the first environment is provided in one of the other faces which are formed in multilayered body 14c by laminating parallelogram plate bodies 14d, and air blow-off port 14f for the second environment is provided in a surface opposed to the surface having air blow-off port 14e for the first environment. In this case, the perspective view in FIG. 6 shows a configuration in which parallelogram plate bodies 14d in FIG. 5 are formed as multilayered body 14c.

Further, the surface provided with air suction port 14a for the first environment is directed to air-blow fan 12, air blow-off port 14e for the first environment is placed in contact with first discharge port 8 in body case 11 and air blow-off port 14f for the second environment is placed in contact with second discharge port 10 in body case 11. Further, heat exchanger device 6 has chamber 16 formed between second air intake port 9 and air suction port 14b for the second environment.

With this configuration, the heat exchanger device 6 has the chamber 16 which is formed between second air intake port 9 and air suction port 14b for the second environment, and can change a direction of the air blower by chamber 16. Accordingly, it is possible to arrange circulation fan 17 serving as an air-blow fan for the second environment in an outer portion of heat exchanger device 6, as mentioned below. Therefore, it is possible to downsize heat exchanger device 6.

Multilayered body 14c of heat exchanger 14 is formed by superposing a plurality of parallelogram plate bodies 14d made of a synthetic resin with predetermined distances. Further, the surface provided with air suction port 14a for the first environment is adjacent to the surface provided with air blow-off port 14e for the first environment at first obtuse angle θ1, and the surface provided with air suction port 14b for the second environment is adjacent to the surface provided with the air blow-off port 14f for the second environment at second obtuse angle θ2.

The surfaces of parallelogram plate bodies 14d forming multilayered body 14c are provided with a plurality of rectification walls 14g which divide the surfaces into a lane shape, as shown in FIGS. 2 and 5. Parallelogram plate body 14d is formed into a parallelogram shape which is longer in a vertical direction, and rectification wall 14g is extended from one end of parallelogram plate body 14d serving as an inflow port toward the other end side. Rectification wall14g is formed into such a shape that is curved to one long side of the parallelogram short of the other end side, and is connected to an outflow port. A plurality of approximately L-shaped air blower lanes are formed on parallelogram plate bodies 14d by the plate-shaped rectification walls 14g as mentioned above.

According to heat exchanger 14 having such a configuration, with regard to the air for the second environment, the short air blower lane is provided close to cabinet 4, and the long air blower lane is provided close to the external portion. On the other hand, with regard to the air for the first environment, the long air blower lane is provided close to cabinet 4, and the short air blower lane is provided close to the external portion.

Heat exchanger 14 as mentioned above is configured such that a bottom surface is formed as an air inflow port close to the external portion, that is, air suction port 14a for the first environment, and each of air outflow ports close to the external portion is connected to first discharge port 8. Further, in heat exchanger 14, a top plate is formed as an inflow port close to inside air, that is, air suction port 14b for the second environment, and each of air outflow ports close to cabinet 4 is connected to second discharge port 10.

Further, air-blow fan 12 for the external air is provided at such a position as to feed in the air toward air suction port 14a for the first environment. In the inflow port of the air inside cabinet 4, that is, air suction port 14b for the second environment, air suction port 14b for the second environment serves as an inclined plane by itself, and chamber 16 is formed between it and the suction port of the air in cabinet 4, that is, second air intake port 9. The air sucked from the inner side of cabinet 4 changes its flow direction by passing through chamber 16, and is sucked into suction port 14b for the second environment.

Further, as shown in FIG. 4, a back surface of heat exchanger device 6 is covered by body case 11, and is configured such that second air intake port 9, heat exchanger 14, second discharge port 10, and air-blow fan 12 are arranged from an upper portion.

Next, a description will be given of an operation and a function of heat exchanger device 6. The air raised to high temperature due to heat generated from the transmitting and receiving portion 5 in cabinet 4 is fed into chamber 16 from second air intake port 9 of heat exchanger device 6 by circulation fan 17 provided in cabinet 4. In this case, an upper portion and a surrounding area of heat exchanger device 6 are covered by cover 21.

On the other hand, the cold external air is sucked from first air intake port 7 by an operation of air-blow fan 12, and is fed to air suction port 14a for the first environment of heat exchanger 14. In heat exchanger 14, a heat exchange is carried out between the cold external air and the air in high temperature cabinet 4. As a result, the cooled air in the cabinet is blown out of second discharge port 10 into cabinet 4, and the external air is discharged to the external portion again from first discharge port 8.

With such a configuration, the air blown from circulation fan 17 in cabinet 4 passes through chamber 16 and flows into air suction port 14b for the second environment of heat exchanger 14 directed to second air intake port 9 side, by using heat exchanger 14 in which its cross section is formed into the parallelogram shape. Accordingly, the air which is heated in cabinet 4 efficiently flows into heat exchanger 14.

Further, since heat exchanger 14 uses the plate body in which the cross sectional shape is the parallelogram shape, a bending angle is smaller in the air blower lane in the inner portion, and a pressure loss can be held down. Further, since the air blowing of the air in cabinet 4 is carried out by using circulation fan 17 provided in cabinet 4, it is possible to hold down a size of body case 11.

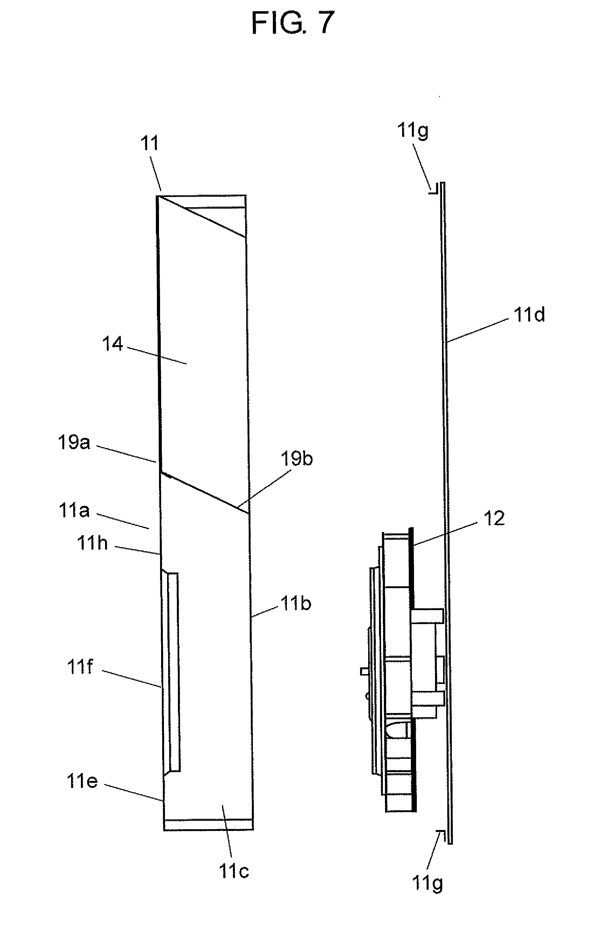

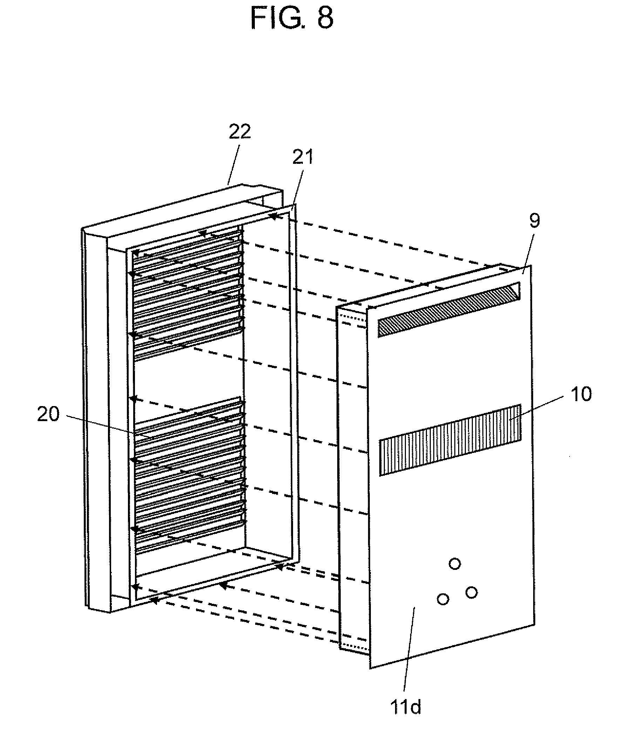

Next, a description will be given of an installation of heat exchanger 14 in body case 11. FIG. 7 is a configuration view of the heat exchanger device according to Embodiment 1 of the present invention as seen from an exploded cross section, and FIG. 8 is a perspective view relating to a cover assembly of the heat exchanger device according to Embodiment 1 of the present invention.

As shown in FIGS. 7 and 8, body case 11 comprises back plate 11d in a back surface side of frame body 11c to which front surface 11a and back surface 11b are open, and box body 11e which has an opening in back plate 11d side, and is provided close to front surface 11a of body case 11. In the opening close to back plate 11d of box body 113, a flange (not shown) protruding to an inner peripheral side is provided in a periphery, and is bonded to back plate 11d according to a screwing or the like. Further, box body 11e is provided with first air intake port 7 and first discharge port 8. First air intake port 7 forms orifice 11f provided in such a manner as to protrude into an impeller of air-blow fan 12.

On the other hand, back plate 11d is provided with air-blow fan 12 provided with second air intake port 9, second discharge port 10 and the motor.

In other words, body case 11 comprises frame body 11c, front plate 11h provided close to front surface 11a of frame body 11c, and back plate 11d provided close to the back surface side of frame body 11c. Further, back plate 11d is provided with second air intake port 9, and second discharge port 10, and is configured such that air-blow fan 12 is fixed thereto.

Packing is attached to a periphery close to box body 11e in an inner surface side of second discharge port 10 provided in back plate 11d. Further, guide wall 11g is provided around back plate 11d in a manner to come into contact with an outer periphery of box body 11e. Guide wall 11g is made higher than a height of orifice 11f provided close to box body 11e. Heat exchanger 14 is installed in such a manner as to be mounted on rail-shaped stand 19a and stand 19b provided in box body 11e, as shown in FIG. 7.

In other words, heat exchanger device 6 according to Embodiment 1 is configured such that stands 19a and 19b mounting heat exchanger 14 thereon are provided in box body 11e.

With such a configuration, heat exchanger 14 is precisely positioned, and is firmly fixed to frame body 11c.

At a time of assembling heat exchanger device 6, heat exchanger 14 is mounted on stands 19a and 19b, and the flanges provided in back plate 11d and box body 11e are bonded thereto. At this time, since a bonding work is carried out along guide wall 11g, in box body 11e, it is possible to easily carry out a normal positioning. Further, guide wall 11g is higher than the height of orifice 11f. Accordingly, even in the case that the bonding work is carried out while box body 11e is shifted, the flange surface of box body 11e and guide wall 11g come into contact with each other, whereby the impeller of air-blow fan 12 does not come into contact with orifice 11f, and is not damaged. At a time of the flanged joint between box body 11e and back plate 11d, the packing is elastically attached closely to second discharge port 10 of heat exchanger 14, thereby carrying out a fixation of heat exchanger 14 and a leakage prevention of the air from the outflow port.

As shown in FIG. 8, heat exchanger device 6 is provided with cover 21 which further includes louver 20 in an outer side of body case 11. Cover 21 is fixed by flange to back plate 11d in such a manner as to cover box body 11e.

In such a configuration, cover 21 is attached to door 22 of cabinet 4 from an inner face side. At a time of maintenance of heat exchanger device 6, door 22 is opened, and body case 11 is detached from the inner side.

In other words, in the heat exchanger device according to Embodiment 1, the back surface side of frame body 11c constructing box body 11e is formed into the flange shape protruding to the inner peripheral side, and the packing is attached to the periphery close to the inner surface of second discharge port 10 provided in back plate 11d. Further, second discharge port 10 and air blow-off port 14f for the second environment are closely attached, at a time of fixing frame body 11c and back plate 11d to the flange.

With this configuration, it is possible to securely fix heat exchanger 14, and prevent the air from leaking from the outflow port.

Further, a peripheral edge portion of back plate 11d is provided with guide wall 11g in a manner to come along an outer periphery of frame body 11c.

With this configuration, the heat exchanger device is easily assembled.

Further, front plate 11h is provided with orifice 11f which leads to the suction port of air-blow fan 12, and guide wall 11g is configured to be higher than the height of orifice 11f.

With this configuration, it is possible to easily assemble the heat exchanger device, and it is possible to rectify the flow of the air caused by air-blow fan 12.

Further, cover 21 fixed to back plate 11d and the flange in a manner to cover box body 11e, and cover 21 has louver 20 formed in the front surface side thereof.

With this configuration, it is possible to protect the configuration parts which are arranged in the inner portion of the heat exchanger device, and it is possible to smoothly suck and discharge the outside air.

### (Embodiment 2)

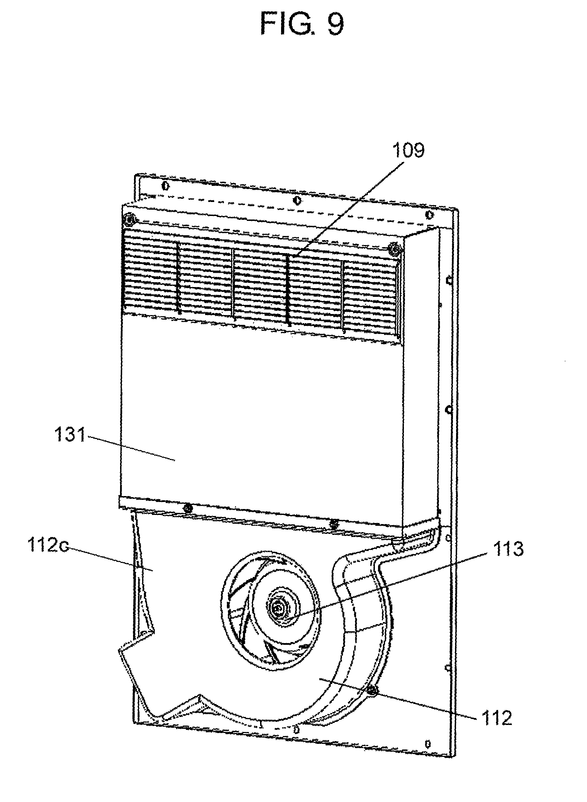

Next, a description will be given of Embodiment 2 according to the present invention with reference to FIGS. 9 to 11.

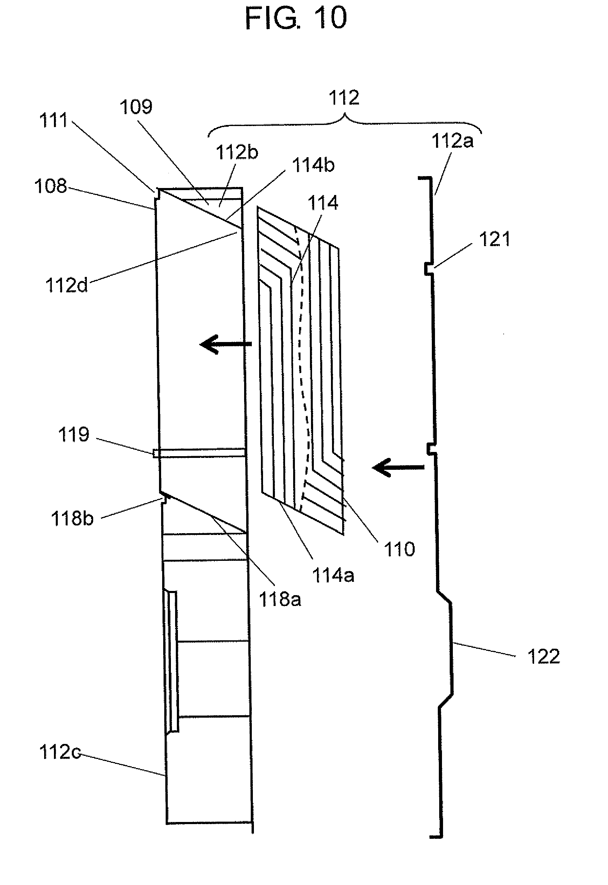

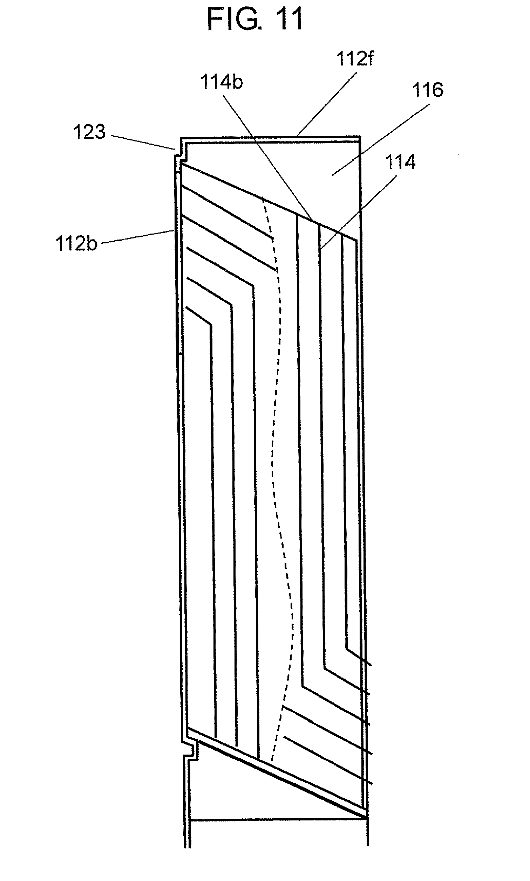

FIG. 9 is a perspective view of a heat exchanger device according to Embodiment 2 of the present invention, and FIG. 10 is a configuration view of an exploded cross section of the heat exchanger device according to Embodiment 2 of the present invention. FIG. 11 is a configuration view of an enlarged cross section of a heat exchanger portion of the heat exchanger device according to Embodiment 2 of the present invention. In this case, the description thereof may sometimes be omitted, with regard to the same components as those of Embodiment 1.

As shown in FIGS. 9 and 10, in Embodiment 2, body case 112 comprises back plate 112a in a back surface side of a frame body in which a front surface and a rear face are open, and box body 112b having an opening in a side of back plate 112a, and is provided in a front surface side of body case 112 (which may be expressed as a front surface side of the frame body). Box body 112b comprises scroll casing 112c which is molded by resin covering air-blow fan 113, and rectangular parallelepiped case 131 which covers heat exchanger 114 and is made of a metal. Wedge shaped depression 112d having a peak in the back surface side is provided in a side surface of box body 112b. Depression 112d bulges to an inner surface side of box body 112b as it is, and forms a wedge shaped protruding portion, although an illustration is omitted. An upper side of the wedge shaped protruding portion serves as support stand 118a supporting heat exchanger 114 in its lower side. In other words, support stand 118a comes to a side provided diagonally so as to descend toward back plate 112a side of box body 112b in such a manner as to be along an inclined lower surface of heat exchanger 114. Further, support stand 118b is provided in such a manner as to connect end portions in a front surface side of support stand 118a. Support stand 118b is formed into a rail shape (not shown) protruding to an inner surface side of box body 112b, and is configured to support the front surface side of heat exchanger 114 from its lower side.

Heat exchanger 114 shown in FIG. 10 is configured, in the same manner as Embodiment 1, such that approximately parallelogram plate bodies are laminated.

Further, cover 115 (not shown) serving as a decorative laminated sheet is provided, in the same manner as Embodiment 1, in a front surface side of the heat exchanger device. Cover 115 is provided with a louver (not shown) for introducing the air in a portion which is opposed to first air intake port 108, and a louver (not shown) for discharging the air in a portion which is opposed to first discharge port 109. In box body 112b, partition 119 is provided in a horizontal direction around box body 112b, between first discharge port 109 and a lower surface (first inflow port 114a), in a portion which comes to an outer hull of heat exchanger 114. Partition 119 comes into contact with an inner surface of cover 115 so as to divide an upper portion (close to first discharge port 109) and a lower portion (close to first air intake port 108).

As shown in FIG. 10, back plate 112a is provided with heat exchanger pressing projection 121 in a horizontal direction, in such a manner as to press heat exchanger 114 to a front surface side. Further, a motor mounting portion of air-blow fan 113 is provided with depression 122 for a motor in such a manner as to protrude to an outer side.

As shown in FIG. 11, top surface protrusion 123 set in such a manner as to press to an inner side of box body 112b is provided in a boundary portion between top surface 112f of box body 112b and a front surface, that is, in a side close to a front surface side of top surface 112f. In this top face protrusion 123, a top portion of heat exchanger 114 is brought into contact with a corner portion close to a front surface side, and chamber 116 is formed between top surface 112f of box body 112b and second inflow port 114b of heat exchanger 114.

With such a configuration, since an outer periphery of air-blow fan 113 is formed as scroll casing 112c, it is possible to efficiently flow a wind toward first inflow port 114a.

Further, since partition 119 is provided in such a manner as to separate between first air intake port 108 and first discharge port 109, it is possible to prevent a shortcut between an intake air and a discharge air.

Further, top surface protrusion 123 forms chamber 116 which secures a distance between the top surface of box body 112b and second inflow port 114b. Accordingly, the air sucked from second air intake port 110 efficiently flows to second inflow port 114b.

In this case, a drive base plate for driving air-blow fan 113 is attached to an outer portion of body case 112. Accordingly, since heat generated from the drive base plate is hard to be conducted to the air which is circulated in heat exchanger 114, and does not deteriorate heat exchange efficiency, it is possible to reduce an influence given to the heat exchange efficiency.

In other words, the heat exchanger device according to the present invention is provided with body case 112, air-blow fan 113 for the first environment, and heat exchanger 114. In this case, body case 112 is provided with first air intake port 108 and first discharge port 109 for the first environment which suck or discharge the outside air, in a front surface thereof, and second air intake port 110 and second discharge port 111 for the second environment which suck or discharge the air in the cabinet, in a back surface thereof. Air blower 113 for the first environment is provided in body case 112. Heat exchanger 114 carries out a heat exchange between the air for the first environment and the air for the second environment, in body case 112.

Heat exchanger 114 is configured such as to include a multilayered body having a plurality of parallelogram plate bodies multilayered with predetermined distances, in the same manner as Embodiment 1. In heat exchanger 114, the air suction port for the first environment and the air suction port for the second environment are provided in two opposed surfaces formed thereon. Air blow-off port 1 for the first environment is provided in one of the other surfaces formed thereon, and the air blow-off port for the second environment is provided in the surface opposed to the surface provided with the air blow-off port for the first environment.

Further, the surface provided with the air suction port for the first environment is directed to air-blow fan 113, and the air blow-off port for the first environment is placed in contact with first discharge port 109 in body case 112, and the air blow-off port for the second environment is placed in contact with second discharge port 111 in body case 112. Further, the heat exchanger device has chamber 116 formed between second air intake port 110 and the air suction port for the second environment.

Further, body case 112 comprises box body 112b having an opening in a back surface side thereof, and back plate 112a provided on a back surface side of box body 112b.

With this configuration, since it is possible to reduce a width of the multilayered body in which a plurality of plate bodes are laminated so as to be superposed, it is possible to further reduce the width of heat exchanger 114, and to thus downsize the heat exchanger device. Further, it has chamber 116 which is formed between second air intake port 110 and the air suction port for the second environment, and it is possible to change the direction of the air blower by this chamber 116. Accordingly, it is possible to arrange a circulation fan serving as the air-blow fan for the second environment in the outer portion of the heat exchanger device. Therefore, it is possible to downsize the heat exchanger device.

Further, box body 112b comprises scroll casing 112c portion formed of a resin material covering the portion having air-blow fan 113 arranged, and the rectangular parallelepiped portion formed of a metal material covering heat exchanger 114.

With this configuration, it is possible to form scroll casing 112c having such a shape as to take into consideration the shape of air-blow fan 113 and the air flow, and heat exchanger 114 can be covered by a cover which is solid and has a good heat conduction. Therefore, it is possible to achieve a compact heat exchanger device in which the heat exchange efficiency is high.

Further, it is configured such that an inner wall surface of box body 112b is provided with rail shaped support stands 118a and 118b which come into contact with a periphery of the first environment air suction port of heat exchanger 114.

With this configuration, it is possible to firmly fix heat exchanger 114 from its lower side.

Further, box body 112b is provided with a wedge shaped protruding portion on an inner wall surface thereof by forming wedge shaped depression 112d having a peak in a back surface side thereof, and an upper side of the wedge shaped protruding portion constitutes a part of support stands 118a and 118b of heat exchanger 114.

With this configuration, it is possible to precisely position heat exchanger 114 so as to firmly fix.

Further, box body 112b is provided with a protrusion on an inner portion thereof where box body 112b is pressed inward at the boundary between top surface 112f of box body 112b and the front surface, and the peak portion of heat exchanger 114 is configured to be brought into contact with a corner portion formed by the protrusion and the front surface of box body 112b.

With this configuration, it is possible to precisely position heat exchanger 114 so as to firmly fix.

Further, back plate 112a is configured to have a projection provided in a manner to press heat exchanger 114 against the front surface side.

With this configuration, it is possible to precisely position heat exchanger 114 so as to firmly fix.

Further, back plate 112a is configured to be provided with a depression for mounting a motor for driving air-blow fan 113.

With this configuration, it is possible to precisely position air-blow fan 113 so as to firmly fix.

### (Embodiment 3)

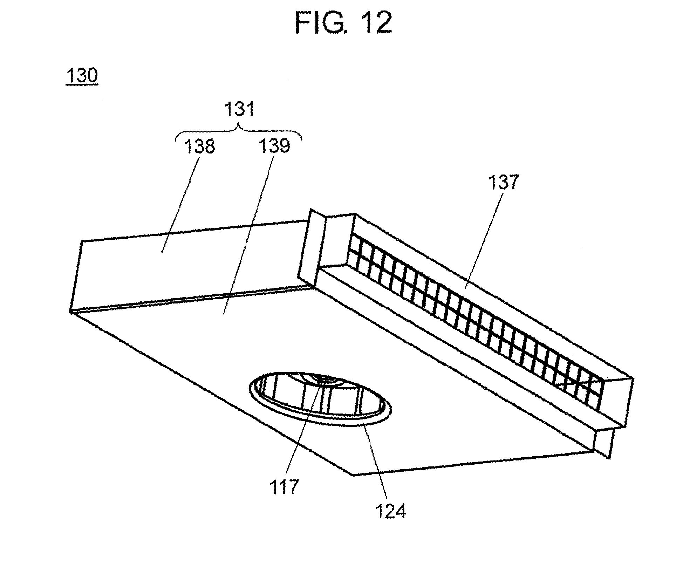

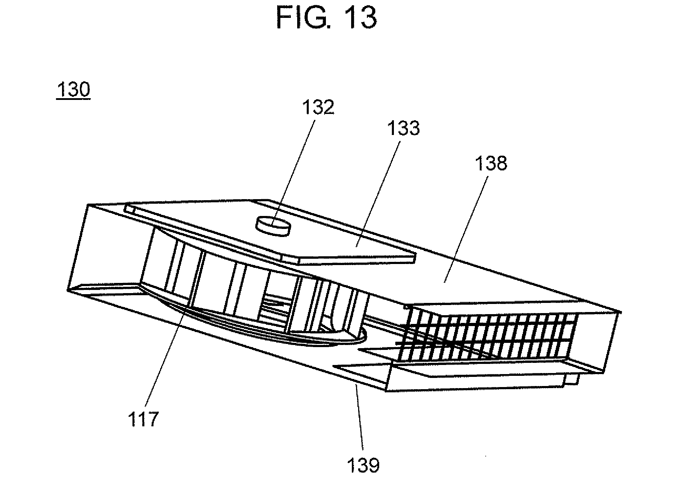

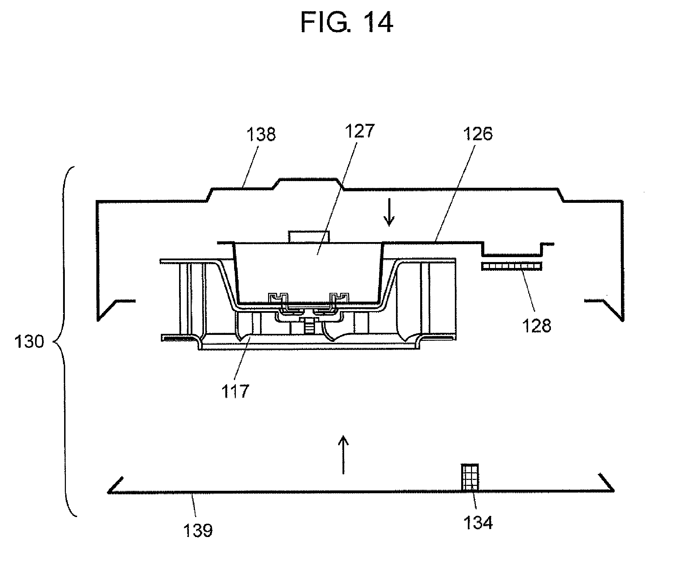

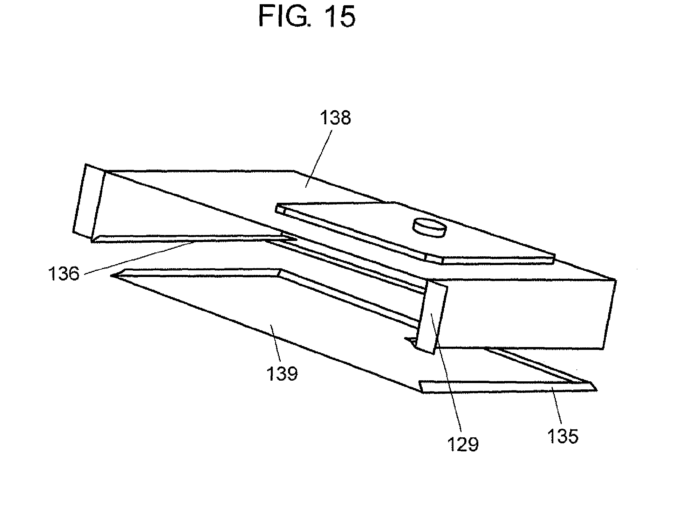

Next, a description will be given of Embodiment 3 according to the present invention with reference to FIGS. 12 to 15. FIG. 12 is a perspective view of a circulation fan portion of a heat exchanger device according to Embodiment 3 of the present invention, and FIG. 13 is a perspective view obtained by cutting a part of the circulation fan portion of the heat exchanger device according to Embodiment 3 of the present invention. FIG. 14 is a configuration view of an exploded cross section of the circulation fan portion of the heat exchanger device according to Embodiment 3 of the present invention, and FIG. 15 is an exploded perspective view of the circulation fan portion of the heat exchanger device according to Embodiment 3 of the present invention.

As shown in FIGS. 12 and 13, in a heat exchanger device according to Embodiment 3, circulation fan 117 is set in box type fan case 131 provided with suction port 124 for a first environment in a bottom surface so as to configure circulation fan unit 130. Fan unit discharge port 137 is provided in a side surface of fan case 131, and is connected to second air intake port 9 of heat exchanger device 6 shown in FIG. 1. Fan case 131 comprises box body 138 which is constituted by a top surface and side surfaces, and bottom plate 139 which constitutes a top surface. One of the side surfaces of box body 138 serves as fan unit discharge port 137.

Further, as shown in FIG. 13, motor 127 of circulation fan 117 is attached to the top surface of box body 138, however, a mounting position of a housing is provided with motor mounting portion 132 which is protruded to an outer side. Further, a periphery of motor mounting portion 132 serving as a mounting position of motor 127 is provided with step portion 133 which is protruded to an outer side in such a manner as to fix a mounting device of motor 127.

FIG. 14 is a vertical cross sectional view of a segmentation cross section at the time of exploding circulation fan unit 130. Circulation fan 117 is attached to motor fixing bracket 126 and is thereafter fixed to box body 138. Step portion 133 is formed in conformity to motor fixing bracket 126. Drive base plate 128 on which a circuit for driving motor 127 is mounted is attached to motor fixing bracket 126. Bottom plate 139 is provided with bottom plate partition plate 134 which divides an area in which drive base plate 128 is provided, and an area in which circulation fan 117 is provided and a blowing air circulates. As shown in FIGS. 14 and 15, a periphery of bottom plate 139 is provided with joining portion 135 which is bent at an acute angle towards box body 138 side. On the contrary, bonding flange 136 coming into surface contact with joining portion 135 is provided in box body 138 side, in such a manner as to be bent inward.

With such a configuration, an upper portion of circulation fan unit 130 can secure a mounting strength of circulation fan 117 by box body 138 provided with a side surface. Further, at the time of maintenance, it can be carried out by setting bottom plate 139 side to an upper side, and detaching bottom plate 139. Further, in box body 138, a strength of the top surface can be secured by step portion 133 for attaching motor fixing bracket 126, and motor mounting portion 132 serving as the protruding portion. Further, since drive base plate 128 serving as a heat generation portion and a section of circulation fan 117 serving as an air-blow path are separated by bottom plate partition plate 134, heat is hard to be conducted to a circulation wind path.

In other words, the heat exchanger device according to the present invention is the heat exchanger device having the same configuration as Embodiments 1 and 2, and is provided with body case 112, air-blow fan 113 for the first environment, and heat exchanger 114. Heat exchanger 114 is configured to include the multilayered body having a plurality of plate bodies multilayered with predetermined distances, in the same manner as Embodiment 2.

Further, the surface provided with the air suction port for the first environment is directed to air-blow fan 113, the air blow-off port for the first environment is placed in contact with first discharge port 109 in body case 112, and the blow-off port for the second environment is placed in contact with second discharge port 111 in body case 112. Further, the heat exchanger device has chamber 116 which is formed between second air intake port 110 and the air suction port for the second environment.

Further, body case 112 comprises box body 138 having an opening in a back surface side thereof, and back plate 112a provided on a back surface side of box body 138.

With this configuration, since it is possible to reduce the width of the multilayered body in which a plurality of plate bodies are laminated and superposed, it is possible to reduce the width of heat exchanger 114, and it is possible to downsize the heat exchanger device. Further, it has chamber 116 which is formed between second air intake port 110 and the air suction port for the second environment, and it is possible to change the direction of the air blower by chamber 116. Accordingly, it is possible to arrange circulation fan 117 serving as the air-blow fan for the second environment in the outer portion of the heat exchanger device. Therefore, it is possible to downsize the heat exchanger device.

Further, a heating element holder according to the present invention comprises heat exchanger device 6, cabinet 4, and circulation fan 117 which have been described in Embodiments 1 to 3 as shown in FIG. 1. In this case, cabinet 4 forms the second environment provided with the heat generating body in the inner portion. Further, circulation fan 117 is provided in the top surface of cabinet 4, and conveys the air in cabinet 4 to the air suction port for the second environment in heat exchanger device 6.

Further, in the heating element holder, fan case 131 receiving circulation fan 117 therein comprises box body 138 in which a frame body and top surface 112f are integrally formed, and bottom plate 139 provided with the air suction port sucking the air in cabinet 4.

With this configuration, it is possible to achieve a compact heating element holder in which heat exchange efficiency is high.

Further, bottom plate of fan case 131 has a bent portion formed by bending a periphery thereof at an acute angle toward box body 138 side, and box body 138 side of fan case 131 has bonding flange 136 formed by bending the periphery of bottom plate side inward in a manner to bond to the bent portion of bottom plate.

With this configuration, the upper portion of circulation fan unit 130 can secure a mounting strength of circulation fan 117 by box body 138 provided with the side surface. Further, at the time of maintenance, it can be carried out by setting bottom plate 139 side to the upper side, and detaching bottom plate 139.

Further, the air blow-off port to heat exchanger device 6 is provided in one of the side surfaces of box body 138 of fan case 131, and bonding flange 136 in the periphery of the air blow-off port connecting to heat exchanger device 6.

With this configuration, the upper portion of circulation fan unit 130 can secure the mounting strength of circulation fan 117, by box body 138 provided with the side surface. Further, at the time of maintenance, it can be carried out by setting bottom plate 139 side to the upper side, and detaching bottom plate 139.

### (Embodiment 4)

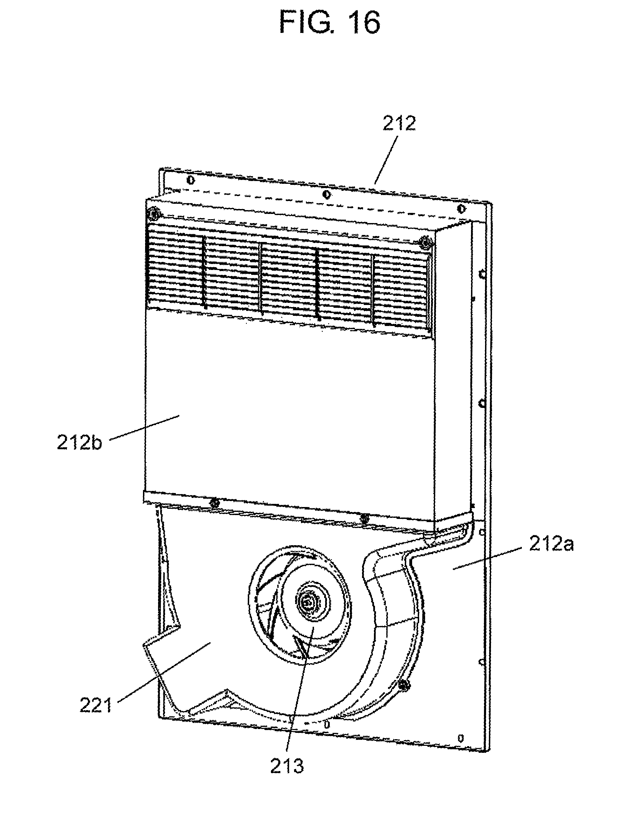

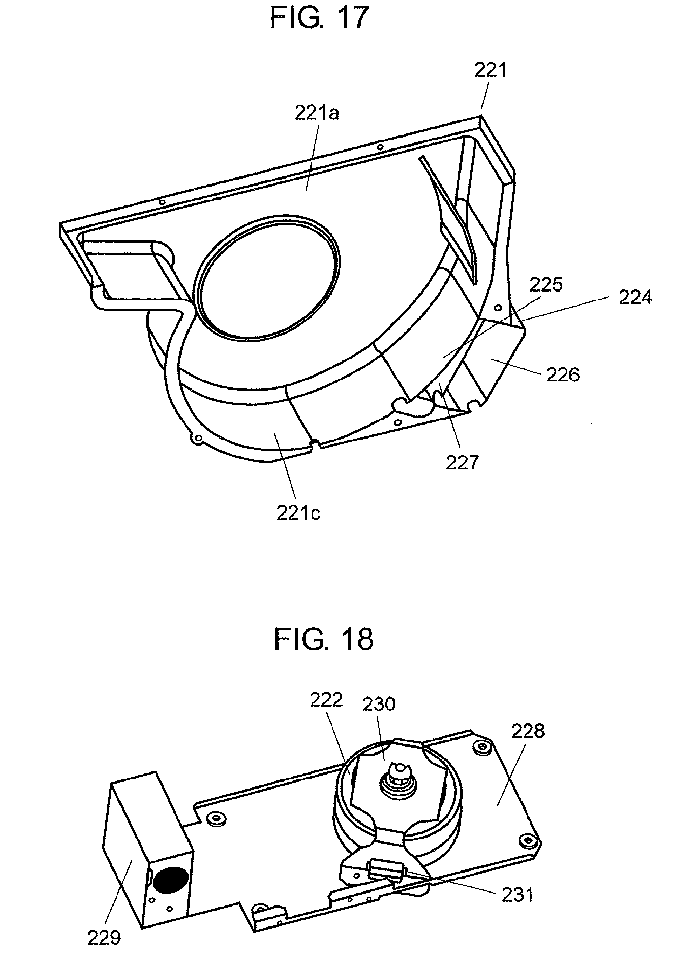

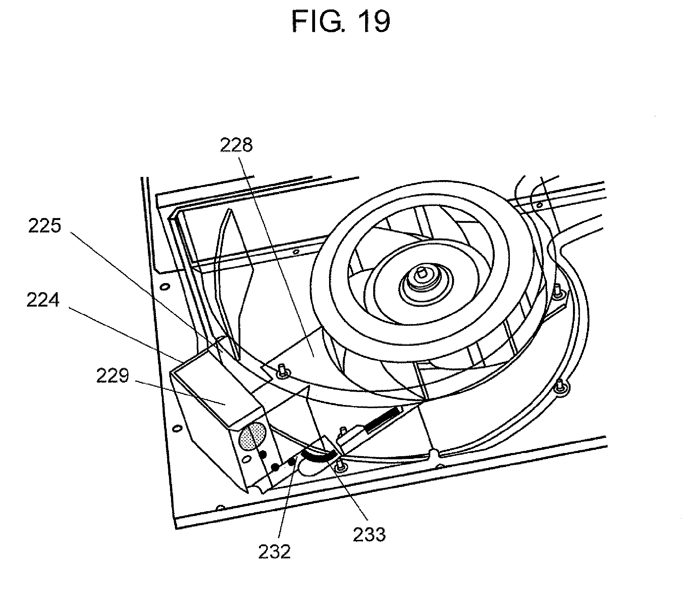

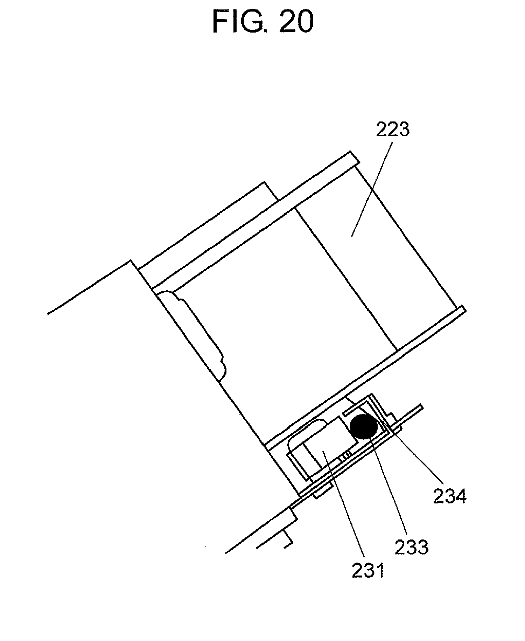

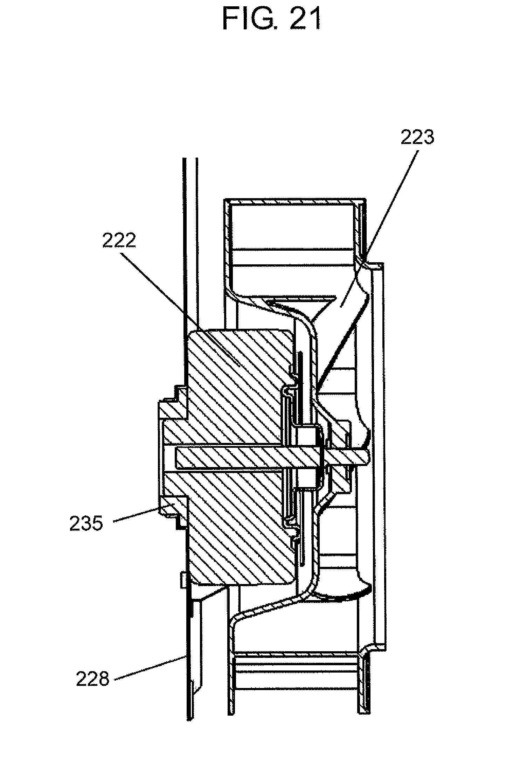

Next, a description will be given of Embodiment 4 according to the present invention with reference to FIGS. 16 to 21. FIG. 16 is a perspective view of a heat exchanger device according to Embodiment 4 of the present invention, and FIG. 17 is a perspective view of a scroll casing of the heat exchanger device according to Embodiment 4 of the present invention. FIG. 18 is a perspective view of a motor fixing plate of the heat exchanger device according to Embodiment 4 of the present invention, and FIG. 19 is a perspective view showing an air-blow fan mounting configuration of the heat exchanger device according to Embodiment 4 of the present invention. FIG. 20 is a plan view obtained by enlarging a main part of an installation of the air-blow fan of the heat exchanger device according to Embodiment 4 of the present invention, and FIG. 21 is a cross sectional view showing a configuration to which a motor of the heat exchanger device according to Embodiment 4 of the present invention is attached.

First of all, a description will be given of air-blow fan 213 with reference to FIGS. 16 to 18.

As shown in FIGS. 16 and 17, body case 212 comprises back plate 212a close to a back surface side, and box body 212b which is open to back plate 212a side, and is provided in a front surface side of body case 212 (which also corresponds to a front surface side of a frame body). Box body 212b comprises scroll casing 221 which is molded with a resin covering air-blow fan 213, and rectangular parallelepiped body case 212 which covers heat exchanger 214 and is made of a metal. Scroll casing 221 comprises suction port side plate 221a provided with an ambient air suction port in a front surface side thereof, side plate 221b opposed to the suction side, and scroll plate 221c. In this case, side plate 221b opposed to the suction side may used in common with back plate 212a.

Motor 222 and centrifugal type impeller 223 attached to a rotating shaft of motor 222 are stored in scroll casing 221. Scroll plate 221c is integrally provided with control box 224 which protrudes out in a diametrical direction. A control circuit (not shown) driving motor 222 is embedded in control box 224. The control box 224 is partitioned from a space provided with impeller 223 by partition wall 225. Partition wall 225 serves as a scroll plate in a section provided with impeller 223. Further, the interior portion of the control box 224 is separated a base plate area 226 and an isolation area 227. Base plate area 226 is provided in an outer side in a diametrical direction of control box 224, and a base plate mounting the control circuit is stored therein. Isolation area 227 is provided between the section provided with impeller 223 and base plate area 226.

As show in FIG. 18, motor 222 is attached to motor fixing plate 228 close to back plate 212a. Motor fixing plate 228 is formed into such a shape as to close a back surface side (back plate 212a side) of control box 224, and control base plate accommodation box 229 mounting the control circuit thereon is provided in a portion closing base plate area 226 in control box 224. Motor fixing plate 228 is attached to base plate 212a. Scroll casing 221 is attached in a state where motor fixing plate 228 and back plate 212a are fixed. Control base plate accommodation box 229 is received in base plate area 226.

Motor 222 is fixed in such a manner as to be sandwiched by motor fixing plate 228 and motor cover 230. Motor cover 230 comprises a portion which is open in a rotating shaft portion and presses motor 222, and a leg portion which is connected to motor fixing plate 228. Motor fixing plate 228 is provided with a slit to which the leg portion is fitted, and can be easily fixed and released by rotating motor cover 230 around the rotating shaft. Further, the leg portion is provided with wiring fixing portion 231. which is fixed through a wiring for driving motor 222, thereby facilitating the fixation of motor 222.

As shown in FIG. 19, the wiring for driving motor 222, that is, lead wire 233 is temporarily put out of scroll plate 221c to scroll casing 221. Thereafter, it is guided from notch 232 provided in base plate area 226 of control box 224 into the control circuit. Further, lead wire 233 is traced into a bend provided in an end portion of motor fixing plate 228, that is, lead wire protection portion 234.

In this case, as shown in FIG. 21, vibration proof rubber 235 is provided between motor 222 and motor fixing plate 228, and makes a vibration of motor 222 hard to be transmitted to back plate 212a.

With such a configuration, the control circuit for driving motor 222 is separated from the area through which the ambient air passes, that is, the area in which impeller 223 is provided. Accordingly, it is possible to obtain an air blower which is not exposed to a dust mixed into the ambient air and has high reliability.

Further, since the control circuit is fixed to motor fixing plate 228 integrally with motor 222, it is possible to easily carry out a wiring work and a thereafter assembling work. Further, isolation area 227 is provided between base plate area 226 and the area in which impeller 223 is provided. Accordingly, the heat generation of the control circuit is hard to be conducted to the blown air.

Further, since isolation area 227 is provided, and the wiring for driving motor 222 is not passed through isolation area 227, the configuration is made such that the dust, a water drop and the like are hard to enter into the control circuit side.

The heat exchanger device using air-blow fan 213 as mentioned above does not directly come into contact with the control circuit even if it sucks the ambient air including the dust and the like from the first air intake port serving as the ambient air intake port. Accordingly, an influence applied to the control circuit by the dust or the like is hard to be generated.

Further, in the heat exchanger device, only air-blow fan 213 is controlled, the control wiring in the apparatus is completed by motor fixing plate 228, and it is possible to assemble with a simple work.

In other words, the heat exchanger device according to the present invention is the heat exchanger device having the same configuration as Embodiments 1 to 3, and body case 212, air-blow fan 213 for the first environment, and heat exchanger 214. Heat exchanger 214 is configured to include the multilayered body having a plurality of plate bodies multilayered with predetermined distances, in the same manner as Embodiment 1.

Further, the surface provided with the air suction port for the first environment is directed to air-blow fan 213, and the air blow-off port for the first environment is placed in contact with the first discharge port formed in body case 212, and the air blow-off port for the second environment is placed in contact with the second discharge port formed in body case 212. Further, the heat exchanger device has a chamber formed between the second air intake port and the air suction port for the second environment.

Further, body case 212 comprises the box body having an opening in a back surface side thereof, and back plate 212a provided on a back surface side of the box body, and air-blow fan 213 is configured as a centrifugal air blower.

With this configuration, it has the chamber which is formed between the second air intake port and the air suction port for the second environment, and it is possible to change the direction of the air blower by the chamber. Accordingly, it is possible to arrange the circulation fan serving as the air-blow fan for the second environment in the outer portion of the heat exchanger device. Therefore, it is possible to downsize the heat exchanger device. Further, since the control circuit integral type centrifugal air blower which is not exposed to the dust is used, it is possible to downsize the heat exchanger device.

Further, the centrifugal air blower comprises motor 222 and impeller 223 encased in scroll casing 221 having suction port side plate 221a provided with an ambient air suction port, side plate 221b opposed to the suction side and scroll plate 221c. Further, scroll plate 221c is provided with control box 224 protruding in a diametrical direction, and containing a control circuit for driving motor 222. Control box 224 is separated from a space housing impeller 223.

With this configuration, it is possible to protect the control circuit from the dust which is sucked into the centrifugal air blower, and it is further possible to downsize the heat exchanger device based on the control circuit integral type configuration.

Further, scroll casing 221 is configured such that suction port side plate 221a and scroll plate 221c are integrally molded by the resin so as to be fixed to side plate 221b opposed to the suction side.

With this configuration, it is possible to further downsize the heat exchanger device.

Further, motor 222 is configured to be fixed to the fixing plate provided on the side opposite the ambient air suction port, and the control circuit is configured to be fixed onto the fixing plate.

With this configuration, it is possible to further downsize the heat exchanger device.

Further, motor 222 is configured to be fixed by the fixing plate, and motor cover 230 which is formed so as to sandwich motor 222 with the fixing plate.

With this configuration, the control circuit is not exposed to the air including the dust, and the centrifugal air blower having high reliability can be obtained. As a result, it is possible to realize a heat exchanger device having high reliability. Further, since motor 222 is firmly and compactly fixed, it is possible to downsize the heat exchanger device.

Further, motor cover 230 has a fixing hole for fixing wiring fixing portion 231 provided in motor 222.

With this configuration, it is possible to bring together the control wiring based on a simple wiring work and to thus assemble with a simple work.

Further, scroll casing 221 is configured to be integrally provided with control box 224.

With this configuration, the control circuit is not exposed to the air including the dust, and it is possible to obtain a centrifugal air blower having high reliability. As a result, it is possible to realize a heat exchanger device having high reliability. Further, it is possible to downsize the heat exchanger device.

Further, scroll casing 221 is provided with a partition plate separating the space of impeller 223 from a section having control box 224.

With this configuration, the control circuit is not exposed to the air including the dust, and it is possible to obtain a centrifugal air blower having high reliability. As a result, it is possible to realize a heat exchanger device having high reliability. Further, it is possible to downsize the heat exchanger device.

Further, scroll casing 221 is configured to be provided with isolation area 227 separating the space of impeller 223 from the section having control box 224.

With this configuration, the control circuit is not exposed to the air including the dust, and it is possible to obtain a centrifugal air blower having high reliability. As a result, it is possible to realize a heat exchanger device having high reliability. Further, it is possible to downsize the heat exchanger device.

Further, an electric wiring connecting the control circuit and motor 222 is routed from the space impeller 223 into control box 224 via the outside of scroll casing 221 without passing through the isolation area 227.

With this configuration, it is possible to bring together the control wiring based on a simple wiring work, and it is possible to assemble with a simple work.

Further, the heating element holder according to the present invention comprises heat exchanger device 6, cabinet 4, and the circulating fan which have been described in Embodiments 1 to 3 as shown in FIG. 1. In this case, cabinet 4 forms a second environment provided with a heat generating body in its inner portion. Further, the circulating fan is provided on a top surface of cabinet 4 for delivering the air in cabinet 4 to the air suction port for the second environment of heat exchanger device 6.

Further, in the heating element holder, the fan case enclosing the circulating fan comprises a box body integrally formed by a frame body and top surface 112f, and bottom plate 139 provided with the air suction port for sucking the air in cabinet 4.

With this configuration, it is possible to realize a compact heating element holder in which heat exchange efficiency is high. Further, the control circuit is not exposed to the air including the dust, and it is possible to obtain a centrifugal air blower having high reliability. As a result, it is possible to realize a heating element holder having high reliability. Further, it is possible to downsize the heating element holder.

### INDUSTRIAL APPLICABILITY

As mentioned above, in the heat exchanger device according to the present invention, it is possible to arrange the circulation fan serving as the air-blow fan for the second environment in the outer portion of the heat exchanger device, and it is possible to downsize the heat exchanger device. Therefore, it becomes extremely useful for the cooling equipment, for example, in the base station of the communication equipment having a limited installation area, and the other outdoor installed equipment.

### REFERENCE MARKS IN THE DRAWINGS

- 1:: Building
- 2:: Rooftop
- 3:: Base station
- 4:: Cabinet
- 5:: Transmitting and receiving portion
- 6:: Heat exchanger device
- 7, 108:: First air intake port
- 8, 109:: First discharge port
- 9, 110:: Second air intake port
- 10, 111:: Second discharge port
- 11, 112,: 212: Body case
- 11a:: Front surface
- 11b: Back face
- 11c:: Frame body
- 11d, 112a, 212a:: Back plate
- 11e, 112b, 138, 212b:: Box body
- 111f:: Orifice
- 11g:: Guide wall
- 12, 113, 213:: Blower fan
- 14, 114, 214:: Heat exchanger
- 14a:: Air suction port for first environment
- 14b:: Air suction port for second environment
- 14c:: Multilayered body
- 14d:: Parallelogram plate body
- 14e:: Air blow-off port for first environment
- 14f:: Air blow-off port for second environment
- 16, 116:: Chamber
- 17, 117:: Circulation fan
- 19a, 19b:: Stand
- 20:: Louver
- 21, 115:: Cover
- 22:: Door
- 112c, 221:: Scroll casing
- 112d:: Depression
- 112f:: Top panel
- 114a:: First inflow port
- 114b:: Second inflow port
- 118a, 118b:: Support stand
- 119:: Partition
- 121:: Heat exchanger pressing projection
- 122:: Depression for motor
- 123:: Top plane protrusion
- 124:: Suction port for first environment
- 126:: Motor fixing bracket
- 127, 222:: Motor
- 128:: Drive base plate
- 130:: Circulation fan unit
- 131:: Case
- 132:: Motor mounting portion
- 133:: Step portion
- 134:: Bottom plate partition plate
- 135:: Joint portion
- 136:: Bonding flange
- 137:: Fan unit discharge port
- 139:: Bottom plate
- 221a:: Suction port side plate
- 221b:: Side plate opposed to suction side
- 221c:: Scroll plate
- 223:: Impeller
- 224:: Control box
- 225:: Partition wall
- 226:: Base plate area
- 227:: Isolation area
- 228:: Motor fixing plate
- 229:: Control base plate storage box
- 230:: Motor cover
- 231:: Wiring fixing portion
- 232:: Notch
- 233:: Lead wire
- 234:: Lead wire protection portion
- 235:: Vibration proof rubber

## Claims

1. A heat exchanger device comprising:
a body case provided with a first air intake port and a first discharge port for a first environment in a front surface thereof, and a second air intake port and a second discharge port for a second environment in a back surface thereof;
an air-blow fan for the first environment provided in the body case; and
a heat exchanger inside the body case for exchanging heat between air in the first environment and air in the second environment, wherein
the heat exchanger includes a multilayered body having a plurality of parallelogram plate bodies multilayered with predetermined distances,
the multilayered body having the multilayered parallelogram plate bodies is provided with an air suction port for the first environment and an air suction port for the second environment in two opposed surfaces thereof, the multilayered body having the multilayered parallelogram plate bodies is further provided with an air blow-off port for the first environment in one of the other surfaces formed thereon, and an air blow-off port for the second environment in another surface opposed to the surface having the air blow-off port for the first environment,
the surface provided with the air suction port for the first environment is directed to the air-blow fan,
the air blow-off port for the first environment is placed in contact with the first discharge port formed in the body case, and the air blow-off port for the second environment is placed in contact with the second discharge port formed in the body case, and
the heat exchanger has a chamber formed between the second air intake port and the air suction port for the second environment.

2. The heat exchanger device according to claim 1, wherein the multilayered body has a parallelogram in cross sectional shape, and
the surface provided with the air suction port for the first environment is adjacent at a first obtuse angle to the surface provided with the air blow-off port for the first environment, and the surface provided with the air suction port for the second environment is adjacent at a second obtuse angle to the surface provided with the air blow-off port for the second environment.

3. The heat exchanger device according to one of claim 1 and claim 2, wherein
the body case comprises a frame body, a front plate and a box body provided in a front surface side of the frame body, and a back plate provided in a back surface side of the frame body,
the second air intake port and the second discharge port are formed in the back plate, and
the air-blow fan is fixed to the back plate.

4. The heat exchanger device according to claim 3, wherein the box body is provided with a stand for mounting the heat exchanger.

5. The heat exchanger device according to claim 3, wherein
a back surface side of the frame body constructing the box body is formed into a flange shape protruding to an inner peripheral side,
a packing is attached around an inner surface side of the second discharge port formed in the back plate, and
the second discharge port and the air blow-off port for the second environment are closely attached when fixing the frame body and the back plate to the flange.

6. The heat exchanger device according to claim 3, wherein the back plate is provided with a guide wall around a peripheral edge portion thereof in a manner to come along an outer periphery of the frame body.

7. The heat exchanger device according to claim 6, wherein the front plate is provided with an orifice guiding to a suction port of the air-blow fan, and the guide wall is made higher than a height of the orifice.

8. The heat exchanger device according to claim 3 further comprising a cover fixed to the back plate and the flange in a manner to cover the box body, and the cover has a louver formed in a front surface side thereof.

9. The heat exchanger device according to claim 1, wherein the body case comprises a box body having an opening in a back surface side thereof, and a back plate provided on the back surface side of the box body.

10. The heat exchanger according to claim 9, wherein the box body comprises a scroll casing portion formed of a resin material covering a portion having the air-blow fan arranged, and a rectangular parallelepiped portion formed of a metal material covering the heat exchanger.

11. The heat exchanger device according to claim 9 or 10, wherein the parallelogram plate body forming the heat exchanger is formed into a parallelogram shape, the surface provided with the air suction port for the first environment is adjacent at a first obtuse angle to the surface provided with the air blow-off port for the first environment, and the surface provided with the air suction port for the second environment is adjacent at a second obtuse angle to the surface provided with the air blow-off port for the second environment.

12. The heat exchanger device according to claim 11, wherein an inner wall surface of the box body is provided with a rail shaped support stand in contact with a periphery of the air suction port for the first environment of the heat exchanger.

13. The heat exchanger device according to claim 12, wherein the box body is provided with a wedge shaped protruding portion on an inner wall surface thereof by forming a wedge shaped depression having a peak in a back surface side thereof, and an upper side of the wedge shaped protruding portion constitutes a part of the support stand of the heat exchanger.

14. The heat exchanger device according to claim 11, wherein the box body is provided with a protrusion on an inner portion thereof where the box body is pressed inward at the boundary between a top face and a front surface, and a top portion of the heat exchanger is brought into contact with a corner portion formed by the protrusion and the front surface of the box body.

15. The heat exchanger device according to claim 9, wherein the back plate has a projection provided in a manner to press the heat exchanger against the front surface side.

16. The heat exchanger device according to claim 9, wherein the back plate is provided with a depression for attaching a motor for driving the air-blow fan.

17. The heat exchanger device according to claim 1, wherein the body case comprises a box body having an opening in a back surface side thereof and a back plate provided on a back surface side of the box body, and the air-blow fan comprises a centrifugal air blower.

18. The heat exchanger device according to claim 17, wherein the centrifugal air blower comprises a motor and an impeller encased in a scroll casing having a suction port side plate provided with an ambient air suction port, a side plate opposed to the suction side and a scroll plate, the scroll plate is provided with a control box protruding in a diametrical direction and containing a control circuit for driving the motor, and the control box is separated from a space housing the impeller.

19. The heat exchanger device according to claim 18, wherein the scroll casing comprises a resin integrally molding the suction port side plate with the scroll plate, and fixed to the side plate opposed to the suction side.

20. The heat exchanger device according to claim 18, wherein the motor is fixed to a fixing plate provided on the side opposite the ambient air suction port, and the control circuit is fixed onto the fixing plate.

21. The heat exchanger device according to claim 20, wherein the motor is fixed by the fixing plate and a motor cover sandwiching the motor with the fixing plate.

22. The heat exchanger device according to claim 21, wherein the motor cover has a fixing hole fixing a wiring fixing portion provided in the motor.

23. The heat exchanger device according to claim 18, wherein the scroll casing is integrally provided with the control box.

24. The heat exchanger device according to claim 23, wherein the scroll casing is provided with a partition plate separating the space of the impeller from a section having the control box.

25. The heat exchanger device according to claim 24, wherein the scroll casing is provided with an isolation area separating the space of the impeller from the section having the control box.

26. The heat exchanger device according to claim 25, wherein an electric wiring connecting the control circuit and the motor is routed from the space of the impeller into the control box via the outside of the scroll casing without passing through the isolation area.

27. A heating element holder comprising:
a heat exchanger device according to any one of claims 1 to 26;
a cabinet containing therein a heat generating body and forming a second environment; and
a circulating fan provided on a top surface of the cabinet for delivering the air in the cabinet to an air suction port for the second environment of the heat exchanger device,
wherein a fan case enclosing the circulating fan comprises a box body of integrally formed frame body and top surface, and a bottom plate provided with an air suction port for sucking the air in the cabinet.

28. The heating element holder according to claim 27, wherein the bottom plate of the fan case has a bent portion formed by bending a periphery thereof at an acute angle toward the box body side, and the box body side of the fan case has a bonding flange by bending a periphery of a bottom plate side inward in a manner to bond to the bent portion of the bottom plate.

29. The heating element holder according to claim 27 or 28, wherein the box body of the fan case is provided with an air blow-off port to the heat exchanger device in one of the side surfaces thereof, and a bonding flange in the periphery of the air blow-off port connecting to the heat exchanger device.
